(19) **Europäisches Patentamt**
**European Patent Office**
**Office européen des brevets**

(11) **EP 2 882 103 B1**

(12) # EUROPEAN PATENT SPECIFICATION

(45) Date of publication and mention
of the grant of the patent:
**29.05.2019 Bulletin 2019/22**

(51) Int Cl.:
***H03K 17/082*** *(2006.01)*

(21) Application number: **13195668.2**

(22) Date of filing: **04.12.2013**

(54) **METHOD AND APPARATUS FOR SHORT CIRCUIT PROTECTION OF POWER SEMICONDUCTOR SWITCH**

VERFAHREN UND VORRICHTUNG FÜR KURZSCHLUSSSCHUTZ EINES LEISTUNGSHALBLEITERSCHALTERS

PROCÉDÉ ET APPAREIL DE PROTECTION CONTRE LES COURTS-CIRCUITS DE COMMUTATEUR À SEMI-CONDUCTEUR DE PUISSANCE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**10.06.2015 Bulletin 2015/24**

(73) Proprietor: **ABB Schweiz AG
5400 Baden (CH)**

(72) Inventors:
• **ALVAREZ VALENZUELA, Rodrigo Alonso
01099 Nürnberg (DE)**
• **LIZAMA, Ignacio
01062 Dresden (DE)**
• **BERNET, Steffen
01062 Dresden (DE)**
• **LAITINEN, Matti
00380 Helsinki (FI)**

(74) Representative: **Kolster Oy Ab
(Salmisaarenaukio 1)
P.O. Box 204
00181 Helsinki (FI)**

(56) References cited:
**EP-A1- 2 424 112       EP-A1- 2 469 710
US-A- 5 689 394       US-A1- 2008 204 087
US-A1- 2013 049 843       US-B1- 6 304 472**

• **Prentice Hall: "EECS 141 - F01 Lecture 10 Interconnect", , 31 December 2000 (2000-12-31), pages 1-5, XP055465952, Retrieved from the Internet:
URL:http://bwrcs.eecs.berkeley.edu/Classes /icdesign/ee141_f01/Lectures/Lecture10-Wir eModels-6up.pdf [retrieved on 2018-04-10]**

**Description**

FIELD OF THE INVENTION

The present invention relates to short circuit protection of power semiconductor switches.

BACKGROUND INFORMATION

Power converters are used in wide variety of applications. A power converter typically comprises one or more semiconductor switches which are used to convert power from one form to another. For example, a DC voltage may be converted to an AC voltage or voltages.

In order to perform the conversion, each of the switches in a power converter is typically controlled into one of two states: an on-state (i.e. a conductive state) and an off-state (i.e. a non-conductive state). Therefore, turning a switch on means, in this context, setting the switch to the on-state. Accordingly, turning a switch off means setting the switch to the off-state.

Applications using electrical power converters, particularly high-power applications, typically require high operating reliability. Therefore, fault protection of the semiconductors in a power converter may be an important part of the converter protection scheme. A fault protection may be required to avoid destruction of the semiconductors in a short circuit situation and to improve the reliability of the converter.

Various short circuit detection schemes have been developed for protecting power electronic switches, such as IGBTs. For example, a short circuit may be detected by measuring of the collector-emitter saturation voltage $V_{CE,SAT}$ of the switch [1,2]. However, the measurement of the $V_{CE,SAT}$ requires a settling time which may increase the response time of the short circuit protection system. Turning off the short circuit current may take about 10 $\mu$s, for example. Such a delay may cause an abrupt rise in the junction temperature of the switch. The temperature may rise by about 50°C in a short period of time, for example. This may cause high mechanical stress in the semiconductor, which may even cause the switch to explode. A possibility of such an uncontrolled failure naturally reduces the reliability of the converter.

In order to achieve a faster response to a short circuit, the semiconductor may be turned off immediately after the short circuit is detected, i.e. before a stable state of the semiconductor is achieved. The short circuit may be detected by measuring the current through the switch with a Rogowski coil [3], for example. However, turning off the semiconductor before the stable state is achieved may also generate stress and induce even destruction of the device.

Short circuit protection may be based on monitoring or controlling the rate of change $di/dt$ of the current through the switch [4, 5]. For example, an abnormal rate of change $di/dt$ may be used as an indicator of a possible short circuit. If a possible short circuit is detected, the control electrode of the switch may be de-charged in order to reduce the current through the switch. If other criteria confirming the short circuit are detected, the switch is turned off. By using this approach, the increase in the current due to a short circuit can be limited. On the other hand, the control electrode may be unnecessarily de-charged even if there is no short circuit. This may increase losses during normal operation.

Implementation of any of the above-mentioned approaches may cause additional expenses in material, development and manufacturing costs, making service more complicated and difficult.

BRIEF DISCLOSURE

An object of the present invention is to provide a method and an apparatus for implementing the method so as to alleviate the above disadvantages. The objects of the invention are achieved by a method and an apparatus which are characterised by what is stated in the independent claims. The preferred embodiments of the invention are disclosed in the dependent claims.

The present short circuit protection method may comprise steps of detecting a short circuit of a power semiconductor switch (e.g. IGBT, MOSFET, etc.), reducing the maximum level of a control terminal voltage (e.g. gate-emitter voltage in IGBT) in order to limit the short circuit current and accelerate the desaturation of the switch, and then turning off the short circuit current. The short circuit may be detected by means of direct or indirect current estimation. The indirect estimation of the current may be based on measuring the bond voltage, for example. The maximum level of the control terminal voltage may be reduced by modulating an output of a driver unit driving the control terminal voltage at a high frequency.

The disclosed method allows fast detection and turn-off of the short circuit current, thus, limiting the energy involved in the short circuit. This minimises the risk of a mechanical damage in the switch during a short circuit, thus enabling savings in cost and service time. The method does not require current sensors for detecting the short circuit and allows effective limitation and fast turn-off of the short circuit current. The method causes no additional losses during normal operation. In fact, the method allows reduction in the on-state conduction losses during normal operation by allowing increase of the gate-emitter voltage in normal operation.

U.S. patent 5,689,394 relates to a power device control system with gate voltage modulation for transistor fault conditions.

BRIEF DESCRIPTION OF THE DRAWINGS

In the following the invention will be described in greater detail by means of preferred embodiments with reference to the attached drawings, in which

Figure 1 is a simplified block diagram of an exemplary implementation of the disclosed method;
Figure 2 shows a simplified model of an IGBT;
Figures 3a to 3c show exemplary waveforms of estimating collector current $i_C$ by comparing a bond voltage $v_{bond}$ with a threshold voltage $v_{ref}$;
Figure 4 shows a simplified exemplary embodiment of a current measurement based on estimation through comparison;
Figure 5 shows a simplified flow diagram for an exemplary short circuit detection scheme able to distinguish different short circuit scenarios;
Figures 6a to 6c show simplified flow diagrams of exemplary responses to different types of short circuits;
Figure 7 shows an exemplary implementation of a power stage suitable for a driver unit of Figure 1;
Figure 8 shows exemplary waveforms the power stage of Figure 7 during a short circuit;
Figure 9 shows a simplified presentation of an exemplary embodiment of the disclosed method in a frequency converter; and
Figures 10a to 10c show exemplary test results for the disclosed method.

DETAILED DISCLOSURE

The present disclosure presents a short circuit protection method for a power semiconductor switch, where a current through the switch is responsive to a control terminal voltage at a control terminal of the switch. The control terminal voltage may be driven by a driver unit. For example the control terminal voltage may be gate-emitter voltage of an IGBT or a MOSFET and the control terminal may be the gate switch. The driver unit may then be a gate driver unit.

Further, the present disclosure presents an apparatus implementing the method.

The method may comprise detecting a short circuit with an indirect current estimation. For example, the current may be estimated on the basis of a bond voltage, i.e. a voltage over a stray inductance formed by a chip bonding of the switch. The short circuit may be detected by comparing the estimated current to a short circuit current limit.

The control terminal voltage may then be controlled on the basis of the comparison. By adjusting the on-state voltage level of the control terminal voltage, the short circuit current may be limited and desaturation of the switch accelerated. After the desaturation has been reached, the switch may be turned off.

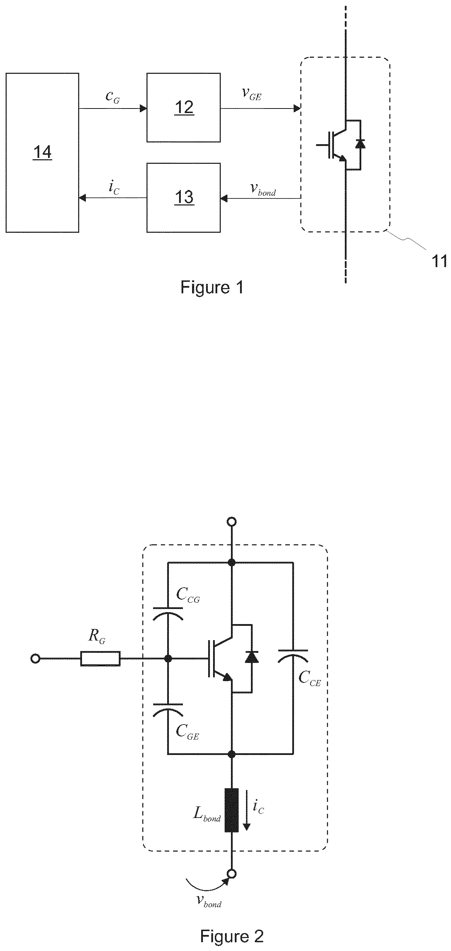

Figure 1 is a simplified block diagram of an exemplary implementation of the disclosed method. A power semiconductor switch 11 in the form of an IGBT is controlled by a driver unit 12 in Figure 1. The driver unit 12 drives the control terminal voltage, which is in this case the gate-emitter voltage $v_{GE}$, of the switch 11. The driver unit 12 is controlled by a controller 14. The controller 14 may also control the switch 11 during normal operation. Normal operation in this context means operation under operating conditions where short circuit has not been detected. For example, the controller 14 may control the power conversion by controlling turn-ons and turn-offs of the switches in the converter. The controller 14 may be an FPGA on a frequency converter, for example.

A current sensing unit 13 estimates a current through the switch 11. For example, the current sensing unit 13 may estimate the collector current $ic$ of the switch 11 by measuring a voltage over an inductance in series with the switch. The voltage over the inductance may be a bond voltage $v_{bond}$, for example. The current sensing unit 13 may estimate the current $ic$ by comparing the measured voltage with a predetermined limit and by measuring the time the bond voltage $v_{bond}$ exceeds the limit. The time may then be used for estimating the current $i_C$.

In Figure 1, a representation of the estimated current is transmitted to a controller 14 which compares it with a short circuit current limit in order to determine if a short circuit has occurred. The controller 14 then controls the control terminal voltage, at the control terminal (in this case the gate) of the switch 11 on the basis of the comparison.

For example, in case of a short circuit, the controller 14 may control the switch 11 directly to off-state. Alternatively, the controller 14 may first desaturate the switch 11 by adjusting the on-state control terminal voltage level. The on-state control terminal voltage may be reduced to a level which limits the current but still exceeds the threshold voltage of the switch. After the switch 11 has been desaturated, the switch may be turned off 11.

Even though the block diagram in Figure 1 shows only one switch, the method is easily applicable to plurality of switches. The fast detection and turn-off of the switch in the disclosed method reduces the energy involved in case of a failure, limiting the temperature rise in semiconductor switches during the failure and avoiding mechanical destruction of the semiconductor switches.

Various aspects of the disclosed method are now discussed in more detail.

A robust estimation of current may be based on measuring the bond voltage $v_{bond}$ across a bonding inductance $L_{bond}$. Figure 2 shows a simplified model of an IGBT. The model shows an internal gate-emitter capacitance $C_{GE}$, collector-gate capacitance $C_{CG}$, and collector-emitter capacitance $C_{CE}$. The model further shows an internal stray capacitance $L_{bond}$ which may represent a chip bonding between the emitter on the IGBT chip and an external emitter terminal of the IGBT module, for example. The model also shows a gate resistance $R_G$ connected to the gate of the IGBT.

The bond voltage $v_{bond}$ is proportional to the slope of the collector current $ic$ in the following manner:

$$L_{bond} \frac{di_C}{dt} = v_{bond} \, . \tag{1}$$

In order to detect a short circuit, the bond voltage $v_{bond}$ may be compared with a set threshold limit thereby generating a digital pulse-like signal where the pulse represents the period the threshold limit is being exceeded. The length of this period is proportional to the value of the collector current $ic$.

The time the bond voltage exceeds the set limit may be measured, and the current may be estimated on the basis of the measured time. If variation of the internal parameters of the IGBTs can be assumed to be within a set range, such as less than 10%, the current estimation is sufficiently accurate for the detection of a short circuit. This allows an extremely simple and fast estimation of the current for the short circuit detection.

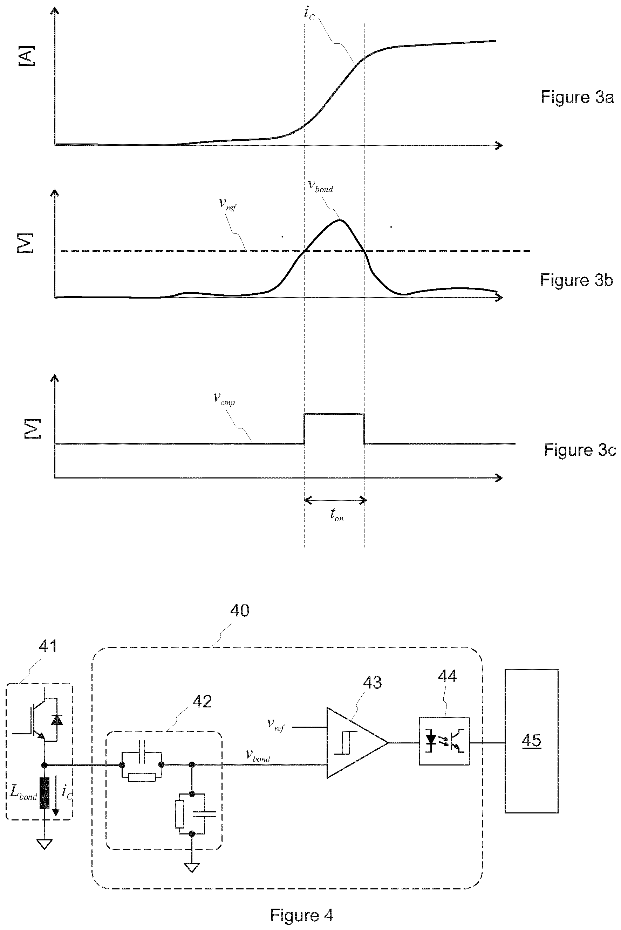

Figure 3a to 3c show exemplary waveforms of estimating collector current $i_C$ by comparing a bond voltage $v_{bond}$ with a threshold voltage $v_{ref}$. During the turn-on transient, the collector current $i_C$ rises in Figure 3a. The bond voltage $v_{bond}$ in Figure 3b follows the rate of change (slope) of the collector current $i_C$. The bond voltage $v_{bond}$ is compared with the threshold voltage $v_{ref}$. The voltage $v_{cmp}$ in Figure 3c represents the output of the comparison. When the bond voltage $v_{bond}$ exceeds the reference voltage $v_{ref}$, the voltage $v_{cmp}$ is set to a high voltage level. Otherwise the voltage $v_{cmp}$ is at a low voltage level. Thus, voltage $v_{cmp}$ forms a pulse-shaped signal. The length $t_{on}$ of the pulse is proportional to the collector current $i_C$ and can be used to estimate the present collector current $i_C$.

Figure 4 shows a simplified exemplary embodiment of a current measurement 40 based on estimation through comparison. The bond voltage $v_{bond}$ of a switch 41 is sensed by using a compensated voltage divider 42. A comparator 43 compares the sensed voltage $v_{bond}$ with a small reference value $v_{ref}$. The comparator output 43 forms a digital pulse-shaped signal which indicates when the rate of change of the collector current $i_C$ of the switch 41 exceeds the reference value. The length of the pulse can be used to approximate the collector current $i_C$.

In Figure 4, the digital signal is transmitted to a controller 45 through an optical isolator 44 which provides a galvanic isolation. The controller 45 evaluates the duration of the pulse in order to detect a short circuit. The controller 45 may simply compare the duration of the pulse with a time limit corresponding with a desired collector current limit, for example.

The above described current estimation approach is able to distinguish between different types of short circuits. For example, it is possible to distinguish a short circuit of type *I*, where the IGBT is turned on into a short circuit, from a short circuit of type *II,* where the short circuit occurs during the IGBT is already in the on-state. This allows use of different time/current limits for the different short circuit types.

If information about the conduction state of the switch or switches is available, for example from a controller of a frequency converter, the information may be used for classifying short circuits into certain short circuit types, which allows the use of different time/current limits. Use of an optimal current limit for a certain short circuit type (e.g. the short circuit type *II* having a lower limit than the short circuit type *I*) allows even faster short circuit detection.

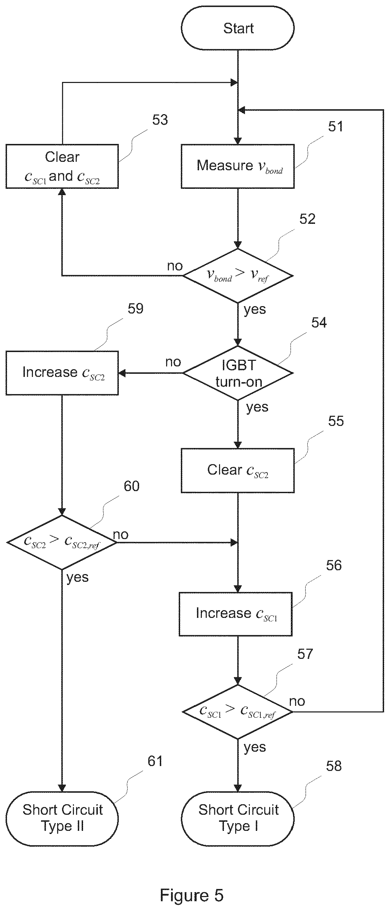

Figure 5 shows a simplified flow diagram for an exemplary short circuit detection scheme able to distinguish the short circuit scenarios of type *I* from scenarios of *II.* Each short circuit type has its own counter which represents a short circuit current. The short circuit current is compared with a limit in order to check if a short circuit condition for the short circuit type in question has been fulfilled. In Figure 5, a counter $c_{SC1}$ represents the short circuit type *I* and a counter $c_{SC2}$ represents type *II*. The counters $c_{SC1}$ and $c_{SC2}$ have their own reference limits $c_{SC1,ref}$ and $c_{SC2,ref}$, respectively.

In Figure 5, the bond voltage $v_{bond}$ is first measured in step 51 and then compared with a reference level $v_{ref}$ in step 52. If the reference level $v_{ref}$ is not exceeded, both counters are clear to zero value in step 53 and the method starts from the first step 51.

If the limit $v_{ref}$ is exceeded, the method proceeds to step 54 where the conduction state of the switch, in this case IGBT, is checked. If the IGBT is being turned on or has just been turned on (e.g. IGBT in on-state for less than 2 μs), the method proceeds to step 55 in which the counter $c_{SC2}$ of the short circuit type *II* is cleared as the short circuit is not of this type. The method then moves to step 56 where the counter $c_{SC1}$ of the short circuit type *I* is increased. In the next step 57, the counter $c_{SC1}$ compared with its reference limit $c_{SC1,ref}$, and if the limit $c_{SC1,ref}$ is exceeded, a short circuit of type *I* is indicated in step 58. If the limit $c_{SC1,ref}$ is not exceeded, the method returns to step 51.

However, if the IGBT is already on in step 54, the method proceeds to step 59, which increases the counter $c_{SC2}$ of the short circuit type *II*. Then, in step 60, the counter is compared with its reference limit $c_{SC2,ref}$. If the limit is exceeded, a short circuit of type *II* is detected in step 61. If the limit is not exceeded, the method proceeds to step 56, and proceeds as described in the previous paragraph.

During a turn-on event, short circuits (of type I) may be detected by comparing the current to a limit which is proportional to a highest allowable current of the switch (e.g. the current rating of the switch).

However, the current may not be expected to rise quickly during the stable on-state. Therefore, the reference limit for the short circuit type *II* may be much lower than the reference limit for the short circuit type *I*. In this manner, short circuits during on-state of the switch, i.e. short circuits of type *II,* can be detected faster.

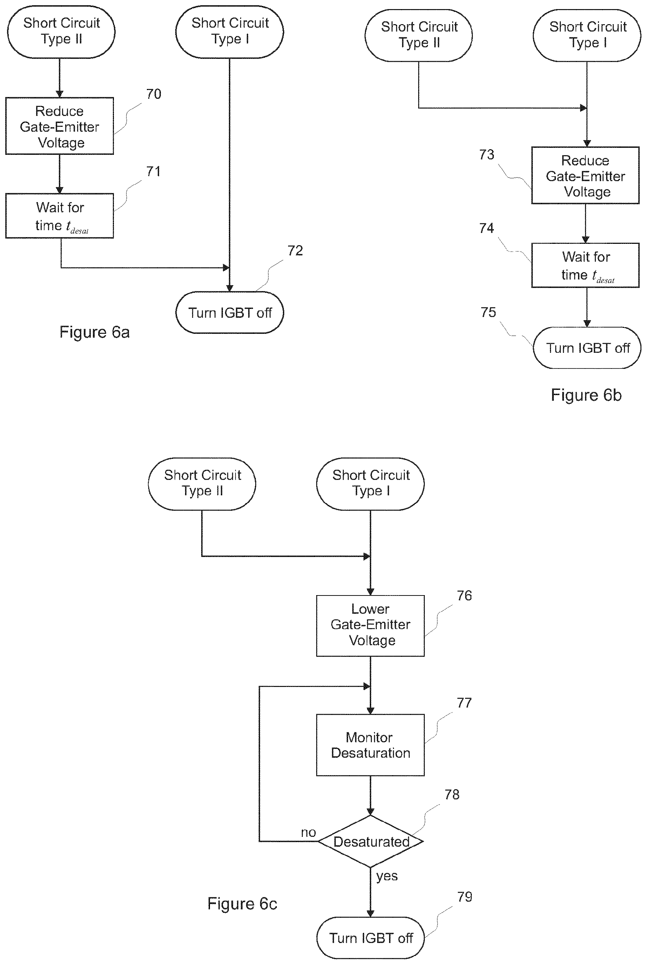

Actions after the detection of the short circuit may vary depending on the type of the short circuit. Figures 6a to 6c show simplified flow diagrams of exemplary responses to different types of short circuits.

In case of a short circuit type *I* of an IGBT, the IGBT can be turned off immediately after the detected short circuit before the IGBT saturates. Figure 6a shows such an approach.

In order to limit the current through a saturated switch and/or ensure desaturation of the switch, the on-state voltage level of the control terminal voltage of a power semiconductor switch may be controlled based on the short circuit. For example, in case of a short circuit type *II* in Figure 6a, the control terminal voltage, in the form of the gate-emitter voltage $v_{GE}$ of the IGBT, is first reduced in step 70 to a value exceeding the threshold voltage of the IGBT in order to generate a faster desaturation of the IGBT and limit the current. After a predetermined time (e.g. 3 μs) from a detected short circuit, the control terminal voltage may be controlled to the off-state voltage level in order to turn the switch off. Step 72 of Figure 6a shows turning off the IGBT after being held at a lowered on-state voltage level for a time $t_{desat}$ in step 71.

Instead of turning the switch instantly off in a short circuit of type *I,* as shown in Figure 6a, the control terminal voltage may be reduced the same way as in the case of the short circuit type *II.* For example, Figure 6b shows a flow diagram where both short circuit types *I* and *II* are followed by a step 73 of using a reduced gate-emitter voltage $v_{GE}$. After waiting a time $t_{desat}$ in step 74, the IGBT is turned off in step 75.

In embodiments where the desaturation of the switch can be detected, the control terminal voltage may be controlled to an off-state voltage level after desaturation has been detected. Figure 6c shows a simplified flow diagram of short circuit protection using desaturation detection. After the detection of a short circuit (of either type), the gate-emitter voltage $v_{GE}$ is reduced in step 76. Then, in step 77, desaturation is monitored. The desaturation may be monitored by using of one of known desaturation detection methods, for example. If desaturation is detected in step 78, the IGBT is turned off in step 79. If not, the method continues by monitoring desaturation again in step 77. In order to ensure that the IGBT is turned off at some point, the method may move to step 79 after a set maximum time even if desaturation has not been detected.

High dynamics for the control of the control terminal voltage can be achieved by utilising structural features of the switch. Internal capacitances of a switch may be utilised to generate low-pass characteristics at the control terminal of the switching device. If the output of a driver unit driving the control terminal voltage is capable of providing a pulse-width-modulated signal at a high frequency, the reduction of the control terminal voltage may be achieved by pulse-width modulating the output of the driver unit at a switching frequency which is at least the cut-off frequency of the low-pass characteristics of the control terminal. The low-pass characteristics filter the pulse-width-modulated driver unit output signal into an essentially DC voltage.

For example, capacitances present at the gate together with the gate resistance complete an RC low-pass filter in the model of Figure 2. The gate resistance and the internal gate-emitter capacitance $C_{GE}$ form the low-pass filter up to the threshold voltage of the switch. For voltages above the threshold voltage, also the collector-gate capacitance $C_{CG}$ affects the cut-off low-pass characteristics. Thus, the cut-off frequency of the filter depends on the capacitances $C_{GE}$ and $C_{CG}$ and the gate resistance. The cut-off frequency may be in the range of 0.5 to 5 MHz, for example. The gate-emitter voltage of the IGBT in Figure 2 may be controlled with very high dynamics when the driver unit output driving the gate-emitter voltage is pulse-width modulated at a high frequency. The switching frequency of the PWM the driver unit may be such that the low-pass characteristics at the gate of the IGBT filter the driver unit output into a signal that is essentially a DC voltage which has its voltage level below the on-state voltage level of the gate-emitter voltage during normal operation.

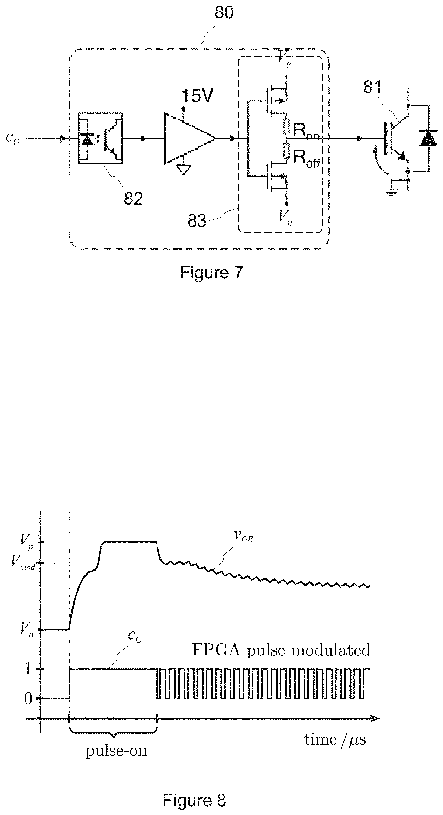

Figure 7 shows an exemplary implementation of a power stage 80 which may be used to drive the gate-emitter voltage $v_{GE}$ of a switch 81 which is an IGBT in Figure 7. The power stage 80 comprises a buffer circuit 82 which is controlled by a control signal $c_G$ through an optical isolator 82. The output of the buffer 82 is converted to IGBT gate voltage levels by using a push-pull output circuit 83. The supply voltages $V_p$ and $V_n$ of the push-pull circuit 83 are generated by a supply unit not shown in Figure 7.

The power stage 80 is able to generate a PWM signal at a high frequency, such as 5 MHz. This PWM signal is filtered by the IGBT 81, and forms a gate-emitter voltage $v_{GE}$.

Figure 8 shows exemplary waveforms of the power stage of Figure 7 during a short circuit. During a turn-on event at instant $t_1$, the control signal $c_G$ controls the output of the push-pull circuit 83 to on-state as part of normal operation. The gate-emitter voltage $v_{GE}$ is driven to the positive supply voltage $V_p$.

However, at instant $t_2$, the short circuit is detected in Figure 8. The gate control signal $c_G$ starts to modulate. As a result, the output of the push-pull circuit 83 switches between the positive supply voltage $V_p$ and the negative supply voltage $V_n$. Since the switching frequency of the modulation is at least the cut-off frequency of the low-pass characteristics present at the gate of the IGBT 81, the modulated voltage is filtered by the low-pass characteristics present in the gate, thus, forming a relatively stable gate-emitter voltage $v_{GE}$. As shown in Figure 8, the stable gate-emitter voltage $v_{GE}$ after instant $t_2$ is a DC voltage with a minor ripple. The voltage level $v_{mod}$ of the gate-emitter voltage $v_{GE}$ is below the level $V_p$ the gate-emitter voltage $v_{GE}$ had during normal operation.

The above approach for adjusting the control terminal voltage is simple and has a high dynamic response. This approach improves the controllability of the short circuit current in case of a failure by reducing the gate-emitter voltage limiting the short circuit current.

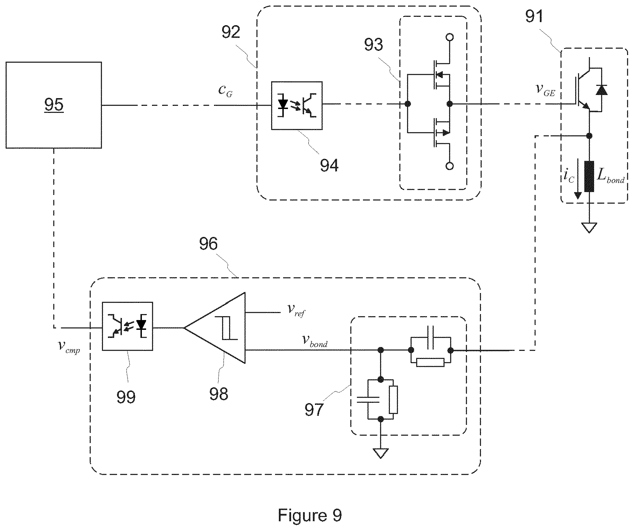

Figure 9 shows a simplified presentation of an exemplary embodiment of the disclosed method in a frequency converter. A short circuit protection apparatus for one of the IGBTs of the frequency converter is shown in Figure 9.

The short circuit protection apparatus comprises a driver unit 92, a current sensing unit 96, and a controller 95. The current through the IGBT 91 is responsive to the gate-emitter voltage $v_{GE}$ of the switch. The driver unit 92 drives the gate-emitter voltage $v_{GE}$ (i.e. the control terminal voltage). The driver unit 92 comprises a push-pull output circuit 93 and a first optocoupler 94. The output voltage of the push-pull output circuit 93 is controlled in response to a control signal $c_G$. A controller 95 provides the control signal $c_G$ to the the push-pull output circuit 93 through the first optocoupler 94 which provides galvanic isolation between the controller 95 and the push-pull circuit 93. In Figure 9, the controller 95 is an FPGA controlling also the switching of the IGBTs of the frequency converter during normal operation. The controller 95 may be used for implementing short circuit protection for all IGBTs in the frequency converter.

In Figure 9, the IGBT has a stray inductance $L_{bond}$ in the path of the collector current $i_C$. The stray inductance $L_{bond}$ is formed by chip bonding. A current sensing unit 96 is configured to estimate the collector current $ic$ by measuring a bond voltage $v_{bond}$ over the stray inductance $L_{bond}$. The current sensing unit 96 uses a compensated voltage divider 97 to measure the bond voltage $v_{bond}$. The current sensing unit 96 further comprises a comparator 98 and a second optocoupler 99. The comparator 98 is configured to compare the bond voltage $v_{bond}$ with a predetermined limit $v_{ref}$ so that the output $v_{cmp}$ of the comparator 98 shows when the bond voltage $v_{bond}$ exceeds the limit $v_{ref}$. The comparator 98 output may be in the form of a digital one-bit signal.

The time the bond voltage $v_{bond}$ exceeds the limit $v_{ref}$ is then used for estimating the collector current $i_C$. In Figure 9, the comparison result $v_{cmp}$ is transmitted to the controller 95 through the second optocoupler 99. The controller 95 compares it with a short circuit current limit in order to determine if a short circuit has occurred.

The controller 95 is configured to control the gate-emitter voltage $v_{GE}$ at the gate of the IGBT 91 on the basis of the detected short circuit. When a short circuit is detected, the controller 95 controls the control signal $c_G$ to pulse-width modulate at high frequency. As a result, the output of the push-pull circuit 93 also modulates. The low-pass characteristics present on the gate of the IGBT 91 filter the modulated output signal forming a DC voltage. In this manner, the gate-emitter voltage $v_{GE}$ is reduced to a value over the IGBT threshold voltage. Thus, the collector current is limited during the short circuit and the IGBT 91 starts to desaturate. After a few microseconds (3 $\mu$s in the studied cases) or, alternatively, the detection of IGBT desaturation, the IGBT 91 is turned off.

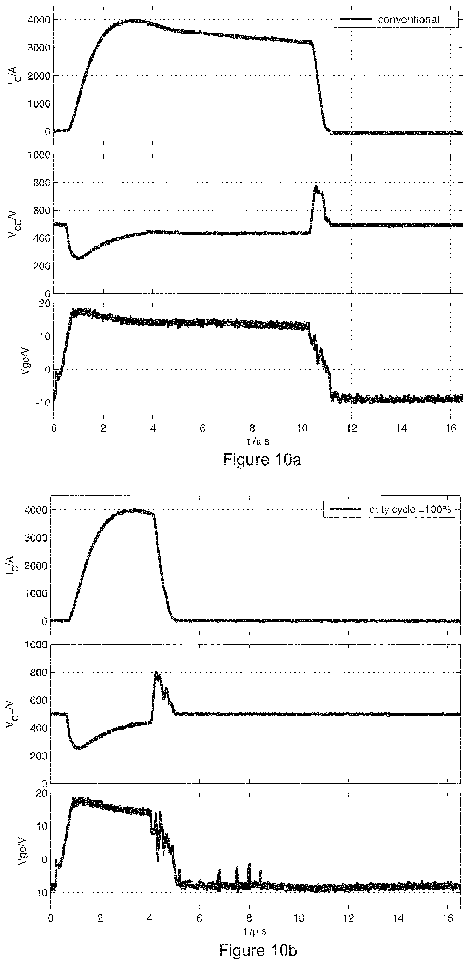

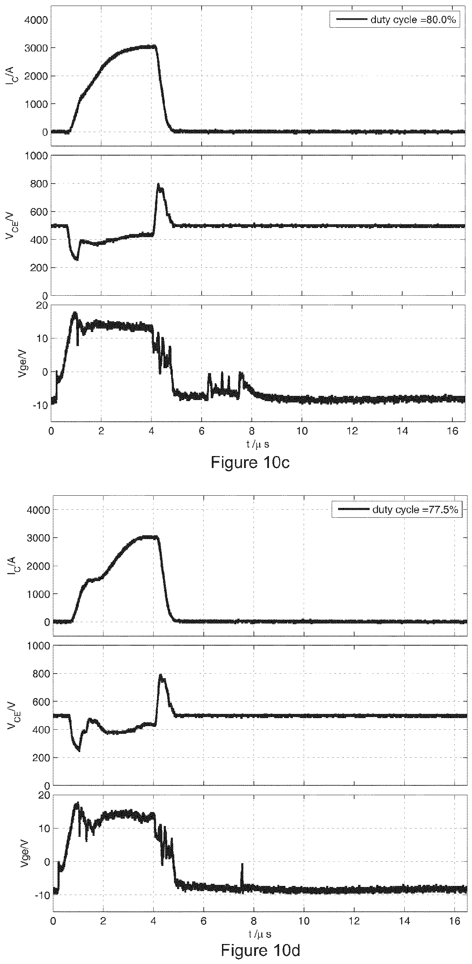

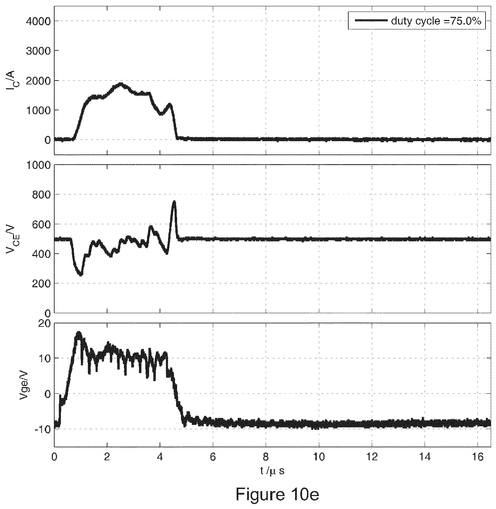

Figures 10a to 10e show exemplary test results for the disclosed method. In Figures 10a to 10e, the disclosed short circuit current detection and limitation method was compared with a conventional method using detection by measurement of the collector-emitter saturation voltage ($V_{CE,SAT}$). The test were performed using an Infineon 1200-V, 1400-A IGBT module FF1400R12IP4. The short circuit detection limit was set to approximately at 1400 A. In the tests, the IGBT was switched to a short circuit, i.e. the detected short circuit was of type *I*. After detecting a short circuit, the disclosed method reduced the gate-emitter voltage to a set level.

The results of the conventional method are shown in Figure 10a. The disclosed method was tested using four different gate-emitter voltage levels, The results at these levels, i.e. at 15 V (100 % duty cycle), at 12 V (80 % duty cycle), at 11.6 V (77.5 % duty cycle), and at 11.3 V (75 % duty cycle), are shown in the Figures 10b to 10e, respectively. In Figures 10a to 10e, the top plots show the collector currents; The middle plots show the respective collector-emitter saturation voltages. The bottom plots show the respective gate-emitter voltages.

The Figures 10a to 10e show that the disclosed method was able to limit the current to 40% or less compared with the current of the conventional method. The faster turn-off of the short circuit reduced the amount of energy of the short circuit and consequently the temperature of the semiconductor during the short circuit. Thus, the disclosed method shows a potential for minimising the mechanical damage in case of a failure. Further, the results show that, with the disclosed method, higher gate-emitter voltages may be used during normal operation in order to reduce the on-state losses.

It is obvious to a person skilled in the art that the inventive concept can be implemented in various ways. The invention and its embodiments are not limited to the examples described above but may vary within the scope of the claims. For example, the disclosed method may be implemented completely in the driver unit of the switch. The disclosed method may be applied to various types of semiconductor switches. The current estimation may be calibrated and the short circuit limits may be adapted depending on the semiconductor switch in question.

Capacitive or inductive measurements of voltage over the stray inductance may be used. The voltages may be measured by using an A/D converter or a plurality of A/D converters. Measurements without a conversion to a digital format are also possible.

In the method of the present disclosure, current may be determined also by other means. For example, a Rogowski coil or a shunt resistor may also be used for measuring a current through a switch. The current may also be estimated by integrating the bond voltage. Following Equation 1, the collector current $i_c$ may be calculated as the integral of the bond voltage $v_{bond}$:

$$\Rightarrow \frac{1}{L_{bond}} \int_{t_1}^{t_2} v_{bond} dt = i_c . \qquad (2)$$

On the basis of Equation 2, the current through a switch may be estimated by integrating a bond voltage (or a voltage over other inductance in series with the switch) for a period of time, measuring the integrated voltage, and estimating the current on the basis of the integrated voltage. The voltage may be measured and integrated by using an analog integrator, for example.

Further, even though an FPGA was mentioned as a platform for implementing the controller, other approaches may also be used. For example, the implementation of the steps of the disclosed method may be carried out by analog electronic circuitry. The control may also be implemented on another digital device, such as a CPU, DSP or a microcontroller.

The variation of the gate-emitter voltage may be implemented by varying a supply voltage of the driver unit or by using several power supplies for the driver unit and switching between those.

REFERENCES

[1] CT-Concept Technologie AG.; "2SP0320T Description & Application Manual,"http://www.igbt-driver.com/fileadmin/Public/PDF/Products/ENG/SCALE-2/PnP/2SP0320/Manuals/2SP0320T_Manual.pdf

[2] Volke, A.; Hornkamp, M.; "IGBT Modules Technologies, Driver and Application," ISBN: 978-3-00-032076-7, Infineon Technologies AG, Munich, 2010.

[3] Gerber, D.; Guillod, T.; Biela, J.; "IGBT gate-drive with PCB Rogowski coil for improved short circuit detection and current turn-off capability," Pulsed Power Conference (PPC), 2011 IEEE ,pp.1359-1364, 19-23 June 2011

[4] Min-Sub, K.; Byoung-Gun, P.; Rae-Young, K.; Dong-Seok, H.; "A novel fault detection circuit for short-circuit faults of IGBT," Applied Power Electronics Conference and Exposition (APEC), 2011 Twenty-Sixth Annual IEEE , pp.359-363, 6-11 March 2011

[5] Belwon, W. A.; Wennerlund, P.; Olin, K.; "An improved overcurrent protection circuit for an IGBT in an inverter." UK Patent GB 2 458 704 A, Application No 0805739.0, Mar. 29, 2008

## Claims

1. A method for a power semiconductor switch (11), wherein a current through the switch (11) is responsive to a control terminal voltage at a control terminal of the switch (11), the control terminal voltage being driven by a driver unit (12), wherein the method comprises:

   measuring or estimating the current,
   detecting a short circuit by comparing the estimated current to a short circuit current limit,
   controlling an on-state voltage level of the control terminal voltage on the basis of the comparison in order to limit the current through the switch (11) during the short circuit, wherein the on-state voltage level voltage is controlled by pulse-width modulating the output of the driver unit (12), wherein a switching frequency of the modulation is at least the cut-off frequency of low-pass characteristics of the control terminal, and subsequently controlling the control terminal voltage to an off-state voltage level in order to turn the switch (11) off, **characterized by** controlling the control terminal voltage to an off-state voltage level comprises detecting desaturation of the switch (11), and controlling the control terminal voltage to an off-state voltage level after desaturation has been detected.

2. A method as claimed in claim 1, wherein the current is estimated on the basis of a bond voltage of the switch (11).

3. A method as claimed in claim 2, wherein estimating the current comprises integrating the bond voltage for a period of time, measuring the integrated voltage, and estimating the current on the basis of the integrated voltage.

4. A method as claimed in claim 2, wherein estimating the current comprises comparing the bond voltage with a set limit, measuring the time the bond voltage exceeds the set limit, estimating the current on the basis of the measured time.

5. A method as claimed in any one of the preceding claims, wherein the low-pass characteristics of the control terminal are formed by capacitances present at the gate together with a gate resistance.

6. A method as claimed in claim 1, wherein the gate resistance and an internal gate-emitter capacitance $C_{GE}$ form the low-pass characteristics of the control terminal.

7. An apparatus for a power semiconductor switch (11), wherein a current through the switch (11) is responsive to a control terminal voltage at a control terminal of the switch (11), the control terminal voltage being driven by a driver unit (12), wherein the apparatus comprises means (13, 14) configured to:

   measure or estimate the current
   detect a short circuit by comparing the estimated current to a short circuit current limit,
   control an on-state voltage level of the control terminal voltage on the basis of the comparison in order to limit the current through the switch (11) during the short circuit, wherein the means are configured to control the on-state voltage level voltage by pulse width modulating the output of the driver unit (12), a switching frequency of the modulation being at least the cut-off frequency of the low-pass characteristics of the control terminal, and subsequently control the control terminal voltage to an off-state voltage level in order to turn the switch (11) off, **characterized by** means configured to control the control terminal voltage to an off-state voltage level comprises means configured to:

   detect desaturation of the switch (11), and
   control the control terminal voltage to an off-state voltage level after desaturation has been detected.

8. An apparatus as claimed in claim 7, wherein the apparatus comprises means (13) configured to estimate the current on the basis of a bond voltage of the switch.

9. A frequency converter comprising the apparatus as claimed in claim 7 or 8.


**Patentansprüche**

1. Verfahren für einen Leistungshalbleiterschalter (11), wobei ein Strom durch den Schalter (11) auf eine Steueranschlussspannung an einem Steueranschluss des Schalters (11) reagiert, wobei die Steueranschlussspannung von einer Treibereinheit (12) angesteuert wird, wobei das Verfahren Folgendes umfasst:

   Messen oder Schätzen des Stroms,
   Detektieren eines Kurzschlusses durch Vergleichen des geschätzten Stroms mit einer Kurzschlussstromgrenze,
   Steuern eines Ein-Zustand-Spannungsniveaus der Steueranschlussspannung auf Basis des Vergleichs, um den Strom durch den Schalter (11) während des Kurzschlusses zu begrenzen, wobei die Ein-Zustand-Spannungsniveauspannung durch Pulsweitenmodulieren des Ausgangs der Treibereinheit (12) gesteuert wird, wobei eine Schaltfrequenz der Modulation mindestens die Grenzfrequenz von Tiefpasseigenschaften des Steueranschlusses ist, und

nachfolgendes Steuern der Steueranschlussspannung auf ein Aus-Zustand-Spannungsniveau, um den Schalter (11) auszuschalten,

**dadurch gekennzeichnet, dass** das Steuern der Steueranschlussspannung auf ein Aus-Zustand-Spannungsniveau Folgendes umfasst

Detektieren einer Entsättigung des Schalters (11), und

Steuern der Steueranschlussspannung auf ein Aus-Zustand-Spannungsniveau, nachdem eine Entsättigung detektiert wurde.

2. Verfahren nach Anspruch 1, wobei der Strom auf Basis einer Bondspannung des Schalters (11) geschätzt wird.

3. Verfahren nach Anspruch 2, wobei das Schätzen des Stroms Folgendes umfasst
Integrieren der Bondspannung für eine Zeitperiode,
Messen der integrierten Spannung, und
Schätzen des Stroms auf Basis der integrierten Spannung.

4. Verfahren nach Anspruch 2, wobei das Schätzen des Stroms Folgendes umfasst
Vergleichen der Bondspannung mit einer eingestellten Grenze,
Messen der Zeit, in der die Bondspannung die eingestellte Grenze überschreitet,
Schätzen des Stroms auf Basis der gemessenen Zeit.

5. Verfahren nach einem der vorhergehenden Ansprüche, wobei die Tiefpasseigenschaften des Steueranschlusses durch Kapazitäten, die am Gate vorhanden sind, zusammen mit einem Gatewiderstand gebildet werden.

6. Verfahren nach Anspruch 1, wobei der Gatewiderstand und eine interne Gateemitterkapazität $C_{GE}$ die Tiefpasseigenschaften des Steueranschlusses bilden.

7. Vorrichtung für einen Leistungshalbleiterschalter (11), wobei ein Strom durch den Schalter (11) auf eine Steueranschlussspannung an einem Steueranschluss des Schalters (11) reagiert, wobei die Steueranschlussspannung von einer Treibereinheit (12) angesteuert wird, wobei die Vorrichtung Mittel (13, 14) umfasst, die zu Folgendem ausgelegt sind:

Messen oder Schätzen des Stroms,
Detektieren eines Kurzschlusses durch Vergleichen des geschätzten Stroms mit einer Kurzschlussstromgrenze,
Steuern eines Ein-Zustand-Spannungsniveaus der Steueranschlussspannung auf Basis des Vergleichs, um den Strom durch den Schalter (11) während des Kurzschlusses zu begrenzen, wobei die Mittel dazu ausgelegt sind, die Ein-Zustand-Spannungsniveauspannung durch Pulsweitenmodulieren des Ausgangs der Treibereinheit (12) zu steuern, wobei eine Schaltfrequenz der Modulation mindestens die Grenzfrequenz der Tiefpasseigenschaften des Steueranschlusses ist, und
nachfolgendes Steuern der Steueranschlussspannung auf ein Aus-Zustand-Spannungsniveau, um den Schalter (11) auszuschalten,
**dadurch gekennzeichnet, dass** Mittel, die dazu ausgelegt sind, die Steueranschlussspannung auf ein Aus-Zustand-Spannungsniveau zu steuern, Mittel umfasst, die zu Folgendem ausgelegt sind:

Detektieren einer Entsättigung des Schalters (11), und
Steuern der Steueranschlussspannung auf ein Aus-Zustand-Spannungsniveau, nachdem eine Entsättigung detektiert wurde.

8. Vorrichtung nach Anspruch 7, wobei die Vorrichtung ein Mittel (13) umfasst, das dazu ausgelegt ist, den Strom auf Basis einer Bondspannung des Schalters zu schätzen.

9. Frequenzwandler, der die Vorrichtung nach Anspruch 7 oder 8 umfasst.

**Revendications**

1. Procédé pour un commutateur à semi-conducteur de puissance (11), dans lequel un courant traversant le commutateur (11) est sensible à une tension de borne de commande au niveau d'une borne de commande du commutateur (11), la tension de borne de commande étant pilotée par une unité de pilotage (12), dans lequel le procédé comprend :

la mesure ou l'estimation du courant,
la détection d'un court-circuit en comparant le courant estimé avec une limite de courant de court-circuit,
la commande d'un niveau de tension à l'état passant de la tension de borne de commande sur la base de la comparaison afin de limiter le courant traversant le commutateur (11) pendant le court-circuit, dans lequel la tension de niveau de tension à l'état passant est commandée par une modulation d'impulsions en durée de la sortie de l'unité de pilotage (12), dans lequel une fréquence de commutation de la modulation est au moins la fréquence de coupure de caractéristiques passe-bas de la borne de commande, et
la commande ultérieure de la tension de borne de commande à un niveau de tension à l'état bloqué afin de mettre le commutateur (11) hors tension,
**caractérisé en ce que** la commande de la tension de borne de commande à un niveau de tension à l'état bloqué comprend
la détection d'une désaturation du commutateur (11), et
la commande de la tension de borne de commande à un niveau de tension à l'état bloqué après qu'une désaturation a été détectée.

2. Procédé selon la revendication 1, dans lequel le courant est estimé sur la base d'une tension de liaison du commutateur (11).

3. Procédé selon la revendication 2, dans lequel l'estimation du courant comprend
l'intégration de la tension de liaison pendant une période de temps,
la mesure de la tension intégrée, et
l'estimation du courant sur la base de la tension intégrée.

4. Procédé selon la revendication 2, dans lequel l'estimation du courant comprend
la comparaison de la tension de liaison avec une limite définie,
la mesure de la durée pendant laquelle la tension de liaison dépasse la limite définie,
l'estimation du courant sur la base de la durée mesurée.

5. Procédé selon l'une quelconque des revendications précédentes, dans lequel les caractéristiques passe-bas de la borne de commande sont formées par des capacités présentes au niveau de la grille conjointement avec une résistance de grille.

6. Procédé selon la revendication 1, dans lequel la résistance de grille et une capacité interne grille-émetteur $C_{GE}$ forment les caractéristiques passe-bas de la borne de commande.

7. Appareil pour un commutateur à semi-conducteur de puissance (11), dans lequel un courant traversant le commutateur (11) est sensible à une tension de borne de commande au niveau d'une borne de commande du commutateur (11), la tension de borne de commande étant pilotée par une unité de pilotage (12), dans lequel l'appareil comprend des moyens (13, 14) configurés pour :

mesurer ou estimer le courant,
détecter un court-circuit en comparant le courant estimé avec une limite de courant de court-circuit,
commander un niveau de tension à l'état passant de la tension de borne de commande sur la base de la comparaison afin de limiter le courant traversant le commutateur (11) pendant le court-circuit, dans lequel les moyens sont configurés pour commander la tension de niveau de tension à l'état passant par une modulation d'impulsions en durée de la sortie de l'unité de pilotage (12), une fréquence de commutation de la modulation étant au moins la fréquence de coupure des caractéristiques passe-bas de la borne de commande, et
commander ultérieurement la tension de borne de commande à un niveau de tension à l'état bloqué afin de mettre le commutateur (11) hors tension,
**caractérisé en ce que** les moyens configurés pour commander la tension de borne de commande à un niveau de tension à l'état bloqué comprennent des moyens configurés pour :

détecter une désaturation du commutateur (11), et
commander la tension de borne de commande à un niveau de tension à l'état bloqué après qu'une désaturation a été détectée.

8.  Appareil selon la revendication 7, dans lequel l'appareil comprend des moyens (13) configurés pour estimer le courant sur la base d'une tension de liaison du commutateur.

9.  Convertisseur de fréquence comprenant l'appareil selon la revendication 7 ou 8.

Figure 1

Figure 2

Figure 3a

Figure 3b

Figure 3c

Figure 4

Figure 5

Short Circuit
Type II

Short Circuit
Type I

Reduce
Gate-Emitter
Voltage                    70

Wait for
time $t_{desat}$            71

                                          72

Turn IGBT off

Figure 6a

Short Circuit
Type II

Short Circuit
Type I

73        Reduce
          Gate-Emitter
          Voltage

74        Wait for
          time $t_{desat}$

75

Turn IGBT off

Figure 6b

Short Circuit
Type II

Short Circuit
Type I

Lower
Gate-Emitter
Voltage                    76

Monitor
Desaturation               77

                                          78

no        Desaturated

          yes

                                          79

Figure 6c

Turn IGBT off

Figure 7

Figure 8

Figure 9

Figure 10a

Figure 10b

Figure 10c

Figure 10d

Figure 10e

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 5689394 A
- GB 2458704 A
- GB 0805739 A

### Non-patent literature cited in the description

- 2SP0320T Description & Application Manual. CT-Concept Technologie AG,
- **VOLKE, A. ; HORNKAMP, M.** IGBT Modules Technologies, Driver and Application. *Infineon Technologies AG,* 2010, ISBN 978-3-00-032076-7
- IGBT gate-drive with PCB Rogowski coil for improved short circuit detection and current turn-off capability. **GERBER, D. ; GUILLOD, T. ; BIELA, J.** Pulsed Power Conference (PPC). IEEE, 2011, 1359-1364
- **MIN-SUB, K. ; BYOUNG-GUN, P. ; RAE-YOUNG, K. ; DONG-SEOK, H.** A novel fault detection circuit for short-circuit faults of IGBT. *Applied Power Electronics Conference and Exposition (APEC), 2011 Twenty-Sixth Annual IEEE,* 06 March 2011, 359-363
- **BELWON, W. A. ; WENNERLUND, P. ; OLIN, K.** *An improved overcurrent protection circuit for an IGBT in an inverter*